# EUROPÄISCHE PATENTSCHRIFT

(11) **EP 1 444 864 B1**
(45) Veröffentlichungstag und Bekanntmachung des Hinweises auf die Patenterteilung: **13.04.2005**
(21) Anmeldenummer: 02805279.3
(22) Anmeldetag: 14.11.2002
(51) Int. Cl.: H04R 19/01, H04R 19/04

(54) **MIKROMECHANISCHE SENSOREN UND VERFAHREN ZUR HERSTELLUNG DERSELBEN**
MICRO-MECHANICAL SENSORS AND METHOD FOR PRODUCTION THEREOF
CAPTEURS MICROMECANIQUES ET PROCEDES DE PRODUCTION DE CES CAPTEURS

(30) Priorität: 11.12.2001 DE 10160830
(43) Veröffentlichungstag der Anmeldung: 11.08.2004
(73) Patentinhaber: Infineon Technologies AG, 81669 München (DE)
(72) Erfinder: DEHE, Alfons, 85375 Neufahrn (DE); FUELDNER, Marc, 85579 München (DE)
(74) Vertreter: Zinkler, Franz, Dipl.-Ing.
(86) Internationale Anmeldenummer: PCT/EP2002/012783
(87) Internationale Veröffentlichungsnummer: WO 2003/055271

(56) Entgegenhaltungen:
- EP-A- 0 979 992
- EP-A- 0 982 575
- US-A1- 2001 015 106
- US-A1- 2001 024 711

## Beschreibung

Die vorliegende Erfindung bezieht sich auf mikromechanische Sensoren und Verfahren zur Herstellung derselben, und insbesondere sogenannte mikromechanische Ein-Chip-Sensoren, zu deren Herstellung lediglich ein Wafer benötigt wird.

Bei mikromechanischen Sensoren, für die ein Silizium-Mikrofon ein Beispiel ist, treten häufig mit Luft gefüllte Hohlräume sehr kleiner Dimension auf. Beim Mikrofon ist dies beispielsweise die luftgefüllte Sensorkapazität, die aus einer empfindlichen Membran und einer starren Gegenelektrode besteht. Aufgrund des kleinen Luftvolumens übt die eingeschlossene Luft eine starke Rückstellkraft auf die Sensormembran aus. Diese Steifigkeit der eingeschlossenen Luft senkt die Empfindlichkeit des Sensors.

Es ist daher bekannt, Ausströmmöglichkeiten für die Luft vorzusehen, wobei dies bei Silizium-Mikrofonen durch eine Perforation der Gegenelektrode geschieht. Durch eine solche Perforation kann die Luft aus dem Kondensatorspalt, d.h. dem Hohlraum zwischen empfindlicher Membran und starrer Gegenelektrode, entweichen.

Aus dem Stand der Technik ist eine große Anzahl von Mikrofonen und mikromechanisch gefertigten Mikrofonen bekannt.

Die kommerziellen Elekret-Mikrofone weisen Geometrien in einer Größenordnung auf, bei denen die Steifigkeit des Luftpolsters vernachlässigbar ist. Diese Mikrofone besitzen nicht die Vorteile eines temperaturstabilen Silizium-Mikrofons in Volumenproduktion.

Bei mikromechanisch gefertigten Mikrofonen sind solche mit elektroplattierter Gegenelektrode bekannt, bei denen die Gegenelektrode abschließend auf dem Mikrofonchip elektroplattiert wird. Hinsichtlich derartiger Mikrofone sei beispielsweise auf Kabir et al., High sensitivity acoustic transducers with p⁺ membranes and gold black-plate, Sensors and Actuators 78 (1999), S. 138-142; und J. Bergqvist, J. Gobet, Capacitive Microphone with surface micromachined backplate using electroplating technology, Journal of Microelectromechanical Systems, Vol. 3, No. 2, 1994, verwiesen. Bei Herstellungsverfahren für derartige Mikrophone können die Löcher in der Gegenelektrode derart groß gewählt werden, daß der akustische Widerstand sehr klein ist und keinen Einfluß auf die Mikrofonempfindlichkeit hat. Nachteilig ist der aufwendige Prozeß der Elektroplattierung.

Aus dem Stand der Technik sind ferner Zwei-Chip-Mikrofone bekannt, bei denen die Membran und die Gegenelektrode jeweils auf getrennten Wafern hergestellt werden. Die Mikrofonkapazität wird dann durch Bonden der beiden Wafer erhalten. Hinsichtlich einer solchen Technologie wird auf W. Kühnel, Kapazitive Silizium-Mikrofone, Reihe 10, Informatik/Kommunikationstechnik, Nr. 202, Fortschrittsberichte, VDI, VDI-Verlag, 1992, Dissertation; J. Bergqvist, Finite-element modelling and characterization of a silicon condenser microphone with highly perforated backplate, Sensors and Actuators 39 (1993), S. 191-200;und T. Bourouina et al., A new condenser microphone with a p⁺ silicon membrane, Sensors and Actuators A, 1992, S. 149-152, verwiesen. Auch bei diesem Mikrofontyp ist es technologisch möglich, ausreichend große Durchmesser für die Löcher der Gegenelektrode zu wählen. Aus Kostengründen werden jedoch Ein-Chip-Lösungen bevorzugt. Darüber hinaus ist die Justage beider Wafer bei den Zwei-Chip-Mikrofonen problematisch.

Bei den bereits angesprochenen Ein-Chip-Mikrofonen wird die Gegenelektrode integriert hergestellt, d.h. es wird nur ein Wafer benötigt. Die Gegenelektrode besteht aus einem Silizium-Substrat und wird durch eine Abscheidung bzw. Epitaxie gebildet. Beispiele für derartige Ein-Chip-Mikrofone sind in Kovacs et al., Fabrication of single-chip polysilicon condenser structures for microphone applications, J. Micromech. Microeng. 5 (1995), S 86-90; und Füldner et al., Silicon microphone with high sensitivity diaphragm using SOI substrate, Proceedings Eurosensors XIV, 1999, S. 217-220, beschrieben. Bei den Herstellungsverfahren für diese Ein-Chip-Mikrofone ist es erforderlich bzw. vorteilhaft, die Löcher in der Gegenelektrode für die folgende Prozessierung wieder zu verschließen, um die Topologie auszugleichen. Bei den bekannten oben genannten elektromechanisch gefertigten Mikrofonen besitzen die Perforationsöffnungen in den Gegenelektroden jeweils eine quadratische bzw. runde Querschnittsform.

Ein Herstellungsverfahren für derartige Ein-Chip-Mikrofone ist aus der WO 00/09440 bekannt. Bei diesem Herstellungsverfahren werden zunächst in einer auf einem Wafer gebildeten epitaktischen Schicht die Perforationsöffnungen erzeugt. Nachfolgend wird eine Oxidabscheidung auf der Vorderseite der Epitaxieschicht durchgeführt, so daß zum einen die Perforationsöffnungen verschlossen und zum anderen eine Abstandsschicht, deren Dicke den späteren Abstand zwischen Membran und Gegenelektrode definiert, gebildet wird. Auf dieser Schicht wird dann eine Silizium-Membran mit der erforderlichen Dicke abgeschieden. Nach der erforderlichen Prozessierung der elektronischen Bauelemente wird im Bereich der Perforationsöffnungen der Wafer von der Rückseite her bis zu der Epitaxieschicht geätzt. Im Anschluß erfolgt von der Rückseite her ein Ätzen des Oxids zum Öffnen der Perforationsöffnungen und des Hohlraums zwischen Membran und Gegenelektrode. Ein Teil der Opferschicht zwischen Membran und Epitaxieschicht bleibt dabei als Abstandsschicht zwischen Membran und Gegenelektrode stehen.

Aus der DE 19741046 C1 ist ein Verfahren zur Herstellung eines Ein-Chip-Mikrofons bekannt, bei dem die Gegenelektrode nach der Erzeugung der Membran sozusagen als abschließender Verfahrensschritt strukturiert wird. Somit ist es bei diesem Verfahren möglich, als Perforationsöffnungen Löcher eines Durchmessers von etwa 25 µm bis 50 µm bzw. Quadrate mit einer Kantenlänge von etwa 25 µm zu erzeugen. Ferner lehrt diese Schrift das Vorsehen von Perforationsöffnungen in der Gegenelektrode, die die Form eines Rechtecks aufweisen, welches sich mit seinen Längsseiten fast über eine gesamte Kantenlänge der quadratischen Gegenelektrode erstreckt, und dessen Breite der oben angegebenen Kantenlänge der Quadrate entspricht.

Schließlich sind aus der US-5,870,482 kapazitive Wandler bekannt, bei denen Randbereiche einer eingespannten Membran zusammen mit einer Gegenelektrode als kapazitive Aufnehmer dienen. Bei einem Beispiel ist eine runde Membran vorgesehen, die in ihrem Mittelabschnitt eingespannt ist, während der äußere Randbereich zusammen mit einer zwischen 1µm und 4µm beabstandeten Gegenelektrode einen Kondensator bildet. In der Gegenelektrode sind 14µm-Schlitze mit einer Beabstandung von 24µm vorgesehen.

Die Aufgabe der vorliegenden Erfindung besteht darin, einen hochempfindlichen mikromechanischen Sensor, der flexibel hergestellt werden kann, und ein Verfahren zum Herstellen eines solchen Sensors zu schaffen.

Diese Aufgabe wird durch einen mikromechanischen Sensor nach Anspruch 1 und ein Verfahren nach Anspruch 13 gelöst.

Die vorliegende Erfindung schafft einen mikromechanischen Sensor mit einer beweglichen Membran und einem der beweglichen Membran über einen Hohlraum gegenüberliegenden Gegenelement, in dem Perforationsöffnungen gebildet sind, wobei die Perforationsöffnungen durch Schlitze gebildet sind, deren Breite maximal dem doppelten des durch den Hohlraum definierten Abstands zwischen der Membran und dem Gegenelement entspricht

Ferner schafft die vorliegende Erfindung ein Verfahren zum Herstellen eines mikromechanischen Sensors mit folgenden Schritten:
Erzeugen von schlitzförmigen Perforationsöffnungen in einer Schicht;
Erzeugen einer im wesentlichen planaren Oxidschicht auf der Schicht, in der die Perforationsöffnungen gebildet sind, mit einer Dicke, die dem späteren Abstand zwischen einem Gegenelement und einer Membran des mikromechanischen Sensors entspricht, unter Verwendung einer vorderseitigen Oxidabscheidung auf die mit den Perforationsöffnungen versehene Schicht, wobei die Breite der schlitzförmigen Perforationsöffnungen maximal dem doppelten der Dicke der Oxidschicht entspricht;
Aufbringen der Membran auf die im wesentlichen planare Oxidschicht; und
Durchführen eines Ätzens zum Öffnen der Perforationsöffnungen und zum Erzeugen eines Hohlraums in der Oxidschicht zwischen der Membran und dem Gegenelement, in dem die Perforationsöffnungen gebildet sind.

Die vorliegende Erfindung baut auf der Erkenntnis auf, daß die Empfindlichkeit von mikromechanischen Sensoren von der Perforationsdichte und der Größe der in einem an einem Sensorhohlraum angrenzenden Element gebildeten Perforationsöffnungen abhängt. Insbesondere bestimmt bei einem mikromechanischen Mikrofon abhängig von der Perforationsdichte und der Größe der einzelnen Löcher der resultierende akustische Widerstand die obere Grenzfrequenz der Mikrofonempfindlichkeit.

Die vorliegende Erfindung beinhaltet eine neuartige Perforation mit schlitzförmigen Löchern, welche vorzugsweise gleichmäßig über das Gegenelement, bei dem bevorzugtem Ausführungsbeispiel eines Silizium-Mikrofons über die Gegenelektrode, angeordnet sind. Gemäß der Erfindung besitzen die Schlitze eine Breite, die maximal dem Doppelten des durch den Hohlraum zwischen Membran und Gegenelement definierten Abständs entspricht, so daß die Prozessierung dieser Perforation ohne weiteres in jeglichem Gesamtprozeß integriert werden kann. Schlitze einer solchen Breite sind bei der Herstellung des erfindungsgemäßen Sensors ohne weiteres durch das Abscheiden der Schicht, die später zur Erzeugung des Hohlraums geätzt wird, verschließbar, da sie beim Abscheiden von beiden Seiten zuwachsen, so dass sich bei den gegebenen Größenverhältnissen ein sicherer Verschluß der Perforationsöffnungen ergibt.

Eine solche maximale Breite der Schlitze, vorzugsweise zusammen mit einer begrenzten Länge derselben, stellt ferner eine ausreichende Stabilität des Gegenelements bzw. der Gegenelektrode sicher. Zusätzlich kann eine definierte Steifigkeit des Gegenelements bzw. der Gegenelektrode sichergestellt werden, wenn die Schlitze in zumindest zwei unterschiedlichen Richtungen ausgebildet sind. Die in unterschiedlichen Richtungen angeordneten Schlitze sind dabei vorzugsweise abwechselnd gleichmäßig über das Gegenelement verteilt. Erfindungsgemäß sind die Schlitze oder Schlitzgruppen jeweils in Reihen und Spalten in dem Gegenelement angeordnet, wobei die Reihen und Spalten versetzt zueinander sind. Der akustische Reibungswiderstand der schlitzförmigen Perforation ist wesentlich geringer als bei den herkömmlichen runden bzw. quadratischen Löchern bei gleichem effektiven Öffnungsgrad.

Erfindungsgemäß werden zur Perforation längliche Gräben anstatt runder bzw. quadratischer Löcher verwendet. Bei gleichbleibender Flächendichte der Perforation wird der viskose Strömungswiderstand der Luft durch die Perforation reduziert, so daß der Einsatzbereich des jeweiligen Sensors, beispielsweise die Bandbreite des Mikrofons erhöht wird. Neben den im folgenden als bevorzugte Ausführungsbeispiele beschriebenen Mikrofonen ist die vorliegende Erfindung auch auf andere mikromechanische Sensoren anwendbar, die einen zwischen einem Gegenelement und einer Membran angeordneten Hohlraum besitzen, wobei lediglich beispielsweise Beschleunigungssensoren, Kraftsensoren und dergleichen genannt sein sollen. Ferner ist die vorliegende Erfindung nicht auf solche Sensoren beschränkt, bei denen eine kapazitive Erfassung stattfindet, sondern ist auch auf Sensoren anwendbar, die einen piezoelektrischen Effekt oder dergleichen zur Erzeugung eines Sensorsignals nutzen.

Bevorzugte Ausführungsbeispiele der vorliegenden Erfindung werden nachfolgend Bezug nehmend auf die beiliegenden Zeichnungen näher erläutert. Es zeigen:
- Fig. 1: Eine schematische Querschnittsansicht eines erfindungsgemäßen mikromechanischen Sensors;
- Fig. 2a: und 2b schematische Darstellungen zur Erläuterung des Strömungswiderstands durch Perforationsöffnungen;
- Fig. 3a: und 3b schematische Darstellungen, die ein Ausführungsbeispiel erfindungsgemäß vorgesehener Perforationsöffnungen zeigen;
- Fig. 4: ein Diagramm, das eine Gegenüberstellung der Mikrofonempfindlichkeit eines erfindungsgemäßen Mikrofons und eines bekannten Mikrofons zeigt;
- Fig. 5,: Fig. 6a und 6b schematische Darstellungen von Perforationsöffnungen gemäß weiteren Ausführungsbeispielen der vorliegenden Erfindung.

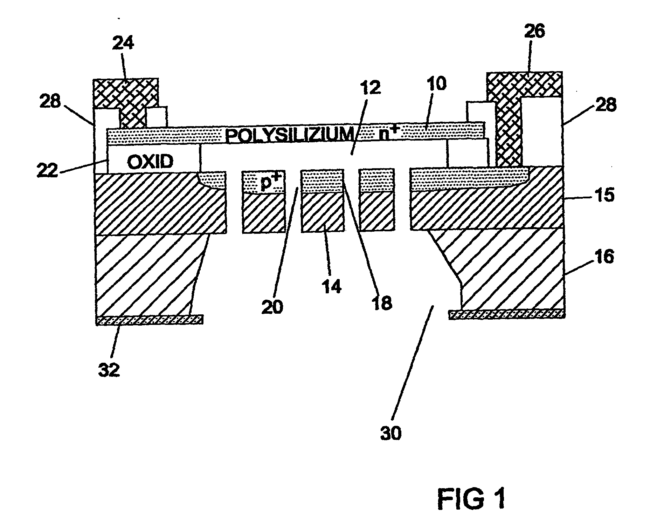

Bezug nehmend auf Fig. 1 sei zunächst allgemein der Aufbau eines erfindungsgemäßen Silizium-Mikrofons beschrieben, wobei ein solches Mikrofon vorteilhaft unter Verwendung des in der WO 00/09440 beschriebenen Verfahrens hergestellt werden kann.

Wie der schematischen Querschnittsansicht von Fig. 1 zu entnehmen ist, weist das Ein-Chip-Silizium-Mikrofon eine bewegliche Membran 10 auf, die aus einem n⁺-dotierten Polysilizium besteht. Der Membran 10 liegt über einen Sensorhohlraum 12 eine Gegenelektrode 14 gegenüber, die durch Bereiche einer auf einem Substrat 16 gebildete Epitaxieschicht 15 gebildet ist. In der Gegenelektrode 14 sind ein p⁺-Dotierungsbereich 18 und Perforationsöffnungen 20 gebildet.

Die Membran 10 ist über eine Abstandsschicht 22, die bei dem gezeigten Ausführungsbeispiel aus Oxid besteht, an der Gegenelektrode angebracht. Eine erste Anschlußelektrode 24 ist mit der Membran 10 elektrisch leitfähig verbunden, während eine zweite Anschlußelektrode 26 mit dem Dotierungsbereich 18 der Gegenelektrode 14 elektrisch leitfähig verbunden ist. Zu diesem Zweck ist in üblicher Weise eine isolierende Schicht 28 vorgesehen.

In dem Substrat 16 ist unterhalb des als Gegenelektrode 14 dienenden Abschnitts der Epitaxieschicht 15 eine Öffnung 30 vorgesehen, so daß die Perforationsöffnungen 20 den Hohlraum 12 mit der Substrat-Öffnung 30 fluidmäßig verbinden. Die Öffnung 30 kann in das Substrat 16 geätzt sein, wobei in Fig. 1 schematisch eine Schicht 32 gezeigt ist, die als Masken-Schicht für ein solchen Ätzen der Öffnung 30 dienen kann.

Da die Funktionsweise des in Fig. 1 gezeigten Sensors für Fachleute klar ist, sei lediglich kurz angemerkt, daß durch die auf Membran 10 auftreffende Schallwellen eine Ablenkung derselben stattfindet, so daß eine Kapazitätsänderung, die aufgrund des geänderten Abstands zwischen der Membran 10 und der Gegenelektrode 14 stattfindet, zwischen den Anschlußelektroden 24 und 26 erfaßt werden kann.

Um den Einfluß von in dem Hohlraum 12 befindlicher Luft auf die Empfindlichkeit und das Ansprechverhalten des Sensors zu reduzieren, sind die Perforationsöffnungen 20, die als Ausströmöffnungen dienen, in der Gegenelektrode vorgesehen. Durch diese Perforationsöffnungen 20 kann die Luft aus dem Kondensatorspalt, d.h. in den Hohlraum 12 entweichen, wobei der resultierende akustische Widerstand abhängig von der Perforationsdichte und der Größe der einzelnen Löcher die obere Grenzfrequenz der Mikrofonempfindlichkeit bestimmt.

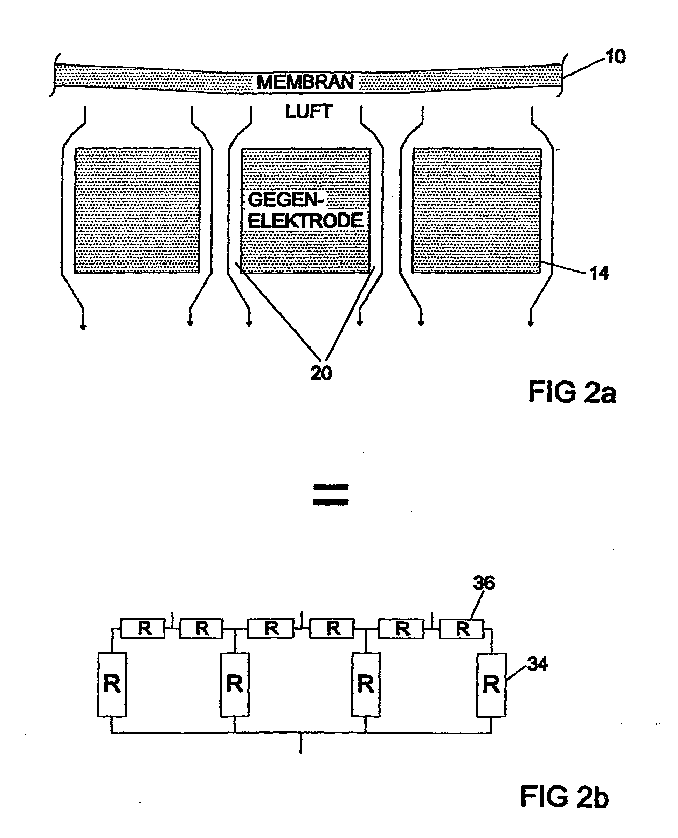

In Fig. 2 ist schematisch ein Abschnitt der Membran 10 in abgelenktem Zustand gezeigt, wobei ferner ein Abschnitt der Gegenelektrode 14 dargestellt ist. Durch die Auslenkung der Membran 10 wird Luft, die sich zwischen Membran 10 und Gegenelektrode 14 befindet, verdrängt und durch die Perforationsöffnungen 20 getrieben. Die Perforationsöffnungen 20 wirken dabei wie eine Parallelschaltung von akustischen Widerständen, wie in Fig. 2b gezeigt ist. Die in Fig. 2b gezeigten groß dargestellten Widerstände 34 stellen dabei den durch eine jeweilige Perforationsöffnung selbst erzeugten akustischen Widerstand dar, während die klein dargestellten Widerstände 36 durch den Strömungswiderstand zu den jeweiligen Perforationsöffnungen hin bedingt sind. Der gesamte Strömungswiderstand setzt sich somit aus einem Anteil parallel zu der Gegenelektrode, d.h. der Strömung zu den Perforationsöffnungen hin, und einem Anteil durch die Perforationsöffnungen hindurch zusammen. Der Strömungswiderstand ist somit durch die Breite, Länge und Höhe der Perforationsöffnungen sowie durch die jeweilige Anordnung und Dichte der Perforationsöffnungen definiert.

Die vorliegende Erfindung schafft mikromechanische Sensoren, bei denen der gesamte Strömungswiderstand und somit der akustische Widerstand deutlich verringert sein kann. Eine solche Verringerung kann nicht einfach dadurch erreicht werden, daß die Perforationsdichte beliebig erhöht wird, da die statische Gegenelektrode hinreichend steif sein muß. Ferner kann der Strömungswiderstand nicht dadurch beliebig verringert werden, daß der Durchmesser bzw. Kantenlänge bekannter runder bzw. quadratischer Perforationsöffnungen beliebig erhöht wird, da derartige Perforationsöffnungen dann durch eine Abscheidung der Schicht 22 mit einer Höhe, die der des Hohlraums entspricht, nicht mehr verschlossen werden können, so daß derartige Mikrofone nur bedingt bzw. mit einem erhöhten Aufwand herstellbar sind. Bei runden bzw. quadratischen Löchern der realisierbaren Größe bewirkt daher der hohe akustische Widerstand der viskosen Rohrströmung einen Abfall der Mikrofonempfindlichkeit bei hohen Frequenzen.

Die vorliegende Erfindung ermöglicht eine deutliche Verringerung des Strömungswiderstands gegenüber den bekannten runden bzw. quadratischen Perforationsöffnungen durch das Vorsehen von schlitzförmigen Perforationsöffnungen. Um eine Verschließbarkeit der Perforationsöffnungen für die folgende Prozessierung, um die Topologie auszugleichen, zu ermöglichen, weisen die schlitzförmigen Öffnungen, d.h. die Gräben, gemäß einem Aspekt der vorliegenden Erfindung eine Breite von maximal dem doppelten des durch den Hohlraum definierten Abstands zwischen der Membran und dem Gegenelement auf. Um jedoch Schichtspannungen in der Oxidschicht, durch die die Perforationsöffnungen verschlossen werden, begrenzt zu halten, und um zu vermeiden, daß dickere Oxidschichten als notwendig abgeschieden werden müssen, weisen erfindungsgemäß die Schlitze vorzugsweise eine Breite von maximal 2 µm auf.

Die Länge der erfindungsgemäßen Schlitze bzw. Gräben kann wesentlich größer gewählt werden, wobei die Länge der Schlitze beispielsweise dem Doppelten oder Dreifachen der Schlitzbreite entsprechen kann. In jedem Fall ist es bevorzugt, daß die Grabenlänge lediglich einem Bruchteil der Abmessungen der freiliegenden Gegenelektrode beträgt, um eine ausreichende Stabilität der Gegenelektrode zu gewährleisten. In jedem Fall beträgt die Länge der einzelnen Schlitze vorzugsweise weniger als die Hälfte der Abmessung der Gegenelektrode.

Durch die Gleichungen zur viskosen, laminaren Rohr- bzw. Spaltströmung kann gezeigt werden, daß der akustische Widerstand eines Grabens bei gleicher Querschnittsfläche wesentlich geringer ist als bei einem runden bzw. quadratischen Loch. Somit erlauben kurze, schmale Gräben eine dichtgepackte Anordnung mit niedrigem Zuströmwiderstand bei gleichzeitig hoher Stabilität der Gegenelektrode.

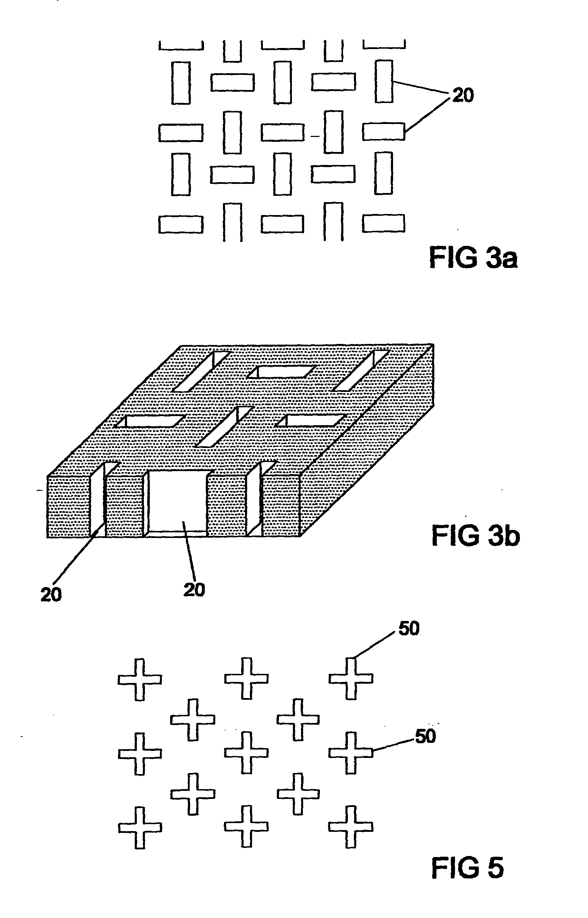

Ein bevorzugtes Ausführungsbeispiel für die Anordnung derartig schlitzförmiger Perforationsöffnungen ist eine periodische und versetzte Anordnung von relativ kurzen und schmalen Gräben, die zum einen einen stark verringerten Strömungswiderstand und zum anderen eine hohe Stabilität der Gegenelektrode sicherstellt. Eine solche Anordnung ist in den Figuren 3a und 3b gezeigt. Die Schlitze 20 verlaufen bei diesem Ausführungsbeispiel in zwei senkrecht zueinander stehenden Richtungen, d.h. längs und quer und in jeder der beiden Richtungen abwechselnd. Fig. 3a zeigt eine Draufsicht auf solche Schlitze, während in Fig. 3b eine schematische perspektivische Darstellung mit Schnitt durch die Gegenelektrode gezeigt ist. Beispielsweise können die in den Fig. 3a und 3b gezeigten Schlitze 20 eine Breite von 1,5 bis 2,5 µm und eine Länge von 5 bis 10 µm aufweisen, wobei die Breite bei einem bevorzugten Ausführungsbeispiel im wesentlichen 2 µm beträgt, während die Länge im wesentlichen 6 µm beträgt.

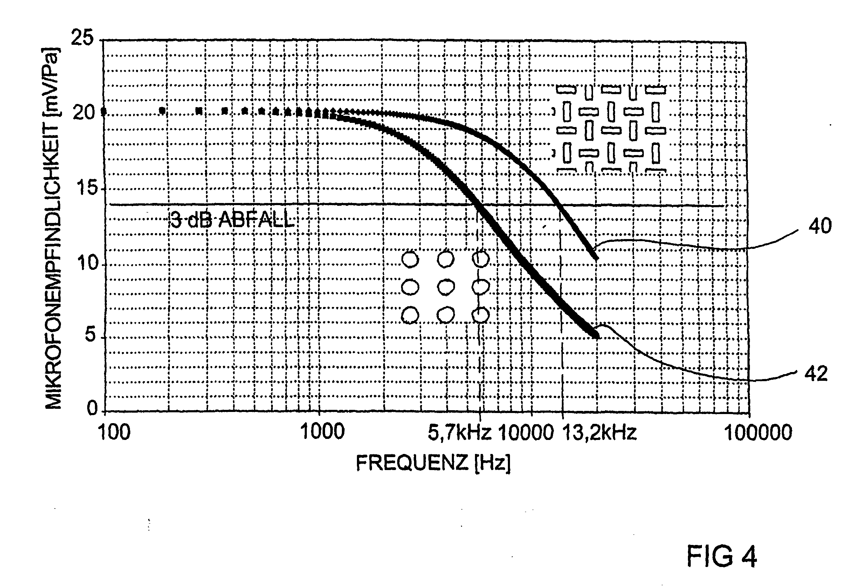

In Fig. 4 zeigt die Kurve 40 die Mikroempfindlichkeit eines Mikrofons, das die in Fig. 3a gezeigte versetzte Struktur von Perforations-Gräben in der Gegenelektrode desselben aufweist, über der Frequenz, während die Kurve 42 die Empfindlichkeit eines herkömmlichen Mikrofons mit runden Perforationsöffnungen darstellt. Bei beiden Mikrofonen beträgt die Perforationsfläche jeweils 25 % von der Gesamtfläche. Der Lochdurchmesser bzw. die Grabenbreite betrugen zur Ermittlung der Kurven 40 und 42 2 µm. Wie aus der in Fig. 4 dargestellten Mikronempfindlichkeit über der Frequenz deutlich zu entnehmen ist, wird durch die erfindungsgemäße Perforation unter Verwendung von Gräben die obere Grenzfrequenz von 5,7 kHz auf 13,2 kHz mehr als verdoppelt.

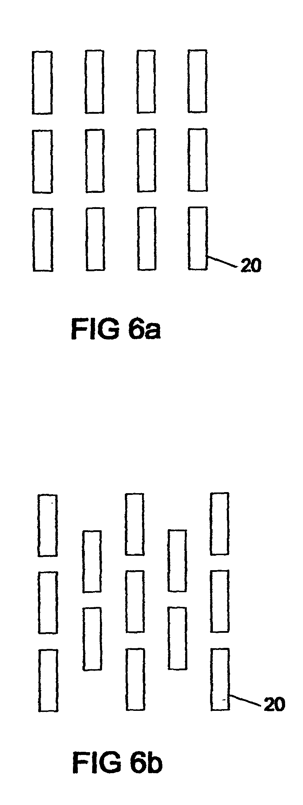

Ein weiteres Ausführungsbeispiel erfindungsgemäßer Perforationsöffnungen ist in Fig. 5 gezeigt. Dort kreuzen sich jeweils zwei in zwei senkrecht zueinander verlaufenden Richtungen angeordnete Perforations-Schlitze und bilden Schlitzkreuze 50. Die Schlitzkreuze 50 sind in Reihen angeordnet, wobei die Schlitzkreuze benachbarter Reihen versetzt zueinander und jeweils in der Mitte zwischen zwei benachbarten Schlitzkreuzen angeordnet sind. Da der Abstand der Grabenwände in der Mitte jedes Schlitzkreuzes 50 größer ist, ist es vorteilhaft, die Grabenbreite etwas kleiner zu dimensionieren als wenn sich die Schlitze nicht kreuzen, um eine Verschließbarkeit der Schlitzkreuze mit Opferoxid zu ermöglichen.

Erfindungsgemäß werden die schlitzförmigen Perforationsöffnungen möglichst gleichmäßig über die Fläche der Gegenelektrode verteilt, wobei zu diesem Zweck die beschriebene versetzte Anordnung vorteilhaft ist. Die Periodizität des regelmäßigen Gitters wird über den Flächenanteil der Perforation an der Gesamtfläche vorgegeben, wobei der gewählte Flächenanteil eine ausreichend steife Gegenelektrode mit aktiver Kondensatorfläche gewährleisten muß. Die versetzte Anordnung hat ferner eine dichte Anordnung der Perforations-Gräben zur Folge, so daß der Strömungswiderstand der Luft von den Zwischenräumen zu den Perforationsöffnungen minimiert ist.

Neben den beschriebenen Ausführungsbeispielen ist es möglich, die in unterschiedlichen Richtungen angeordneten Schlitze mit einem anderen Winkel als 90° zwischen denselben anzuordnen, wobei noch der Vorteil einer erhöhten Stabilität der Gegenelektrode realisiert ist. Vorzugsweise sind die in unterschiedlichen Richtungen angeordneten Schlitze abwechselnd zueinander angeordnet, wobei es möglich ist Schlitze in mehr als zwei unterschiedlichen Richtungen anzuordnen.

Eine alternative Anordnung von Perforationsschlitzen ist in Fig. 6a gezeigt, bei der die Perforationsschlitze in der gleichen Richtung jeweils in Reihen und Spalten ohne Versatz zwischen denselben angeordnet sind. In Fig. 6b ist noch eine weitere alternative Anordnung gezeigt, bei der die Perforationsschlitze in der gleichen Richtung in Reihen und Spalten angeordnet sind, wobei jedoch die Schlitze benachbarter Spalten versetzt zueinander sind.

Erfindungsgemäß trägt sowohl die geringe Schlitzbreite als auch die Anordnung der Perforations-Schlitze in unterschiedlichen Richtungen zu einer erhöhten Stabilität der Elektrode verglichen mit bekannten Sensoren bei. Eine weitere Erhöhung der Stabilität kann durch die beschriebene periodische und versetzte Anordnung relativ kurzer, schmaler Gräben erreicht werden. Die schmalen Gräben erlauben ferner den Einsatz beliebiger Herstellungsverfahren, bei denen die Sensormembran nach der Erzeugung der Perforationsöffnungen hergestellt wird.

Ein bevorzugtes Ausführungsbeispiel eines erfindungsgemäßen Verfahrens zum Herstellen des mikromechanischen Sensors, der in Fig. 1 gezeigt ist, wird nun kurz erläutert. Bei diesem Verfahren werden zunächst die schlitzförmigen Perforationsöffnungen 20 in der Epitaxieschicht 15, die vorzugsweise bereits mit dem p⁺-dotierten Bereich 18 versehen ist, gebildet, während die Öffnung 30 noch nicht in dem Substrat 16 vorgesehen ist. Nach dem Erzeugen der schlitzförmigen Perforationsöffnungen 20 wird die Oxidschicht 22 in der erforderlichen Dicke abgeschieden, wobei dabei die Perforationsöffnungen verschlossen werden. Die Perforationsöffnungen 20 weisen daher eine solche Breite auf, die beim Abscheiden der Oxidschicht 22 mit der bestimmungsgemäßen Dicke einen Verschluß der Öffnungen erlaubt und die ferner eine im wesentlichen planare Oberfläche der abgeschiedenen Oxidschicht 22 zur Folge hat. Im Anschluß kann dann auf der Oxidschicht 22 direkt die Silizium-Membran 10 erzeugt werden.

Im Anschluß wird die Vorderseite der sich ergebenden Struktur weiter prozessiert, beispielsweise um die Anschlüsse 24 und 26 zu bilden, wobei vorzugsweise in benachbarten Bereichen der Epitaxieschicht elektronische Bauelemente in herkömmlicher Weise hergestellt werden. Abschließend wird dann unter Verwendung einer entsprechenden Maskenschicht 32 das Substrat 16 von der Rückseite her geöffnet, um die mit dem Oxid verschlossenen Perforationsöffnungen freizulegen. Im Anschluß erfolgt in herkömmlicher Weise ein selektives Ätzen des in den Perforationsöffnungen 20 angeordneten Oxids sowie der Oxidschicht 22, um den Hohlraum 12 zu erzeugen. Hinsichtlich eines solchen Verfahrens zur Herstellung eines mikromechanischen Sensors, mit Ausnahme der als Schlitze ausgebildeten Perforationsöffnungen, sei auf die WO 00/09440 verwiesen.

### Bezugszeichenliste

- 10: Membran
- 12: Sensorhohlraum
- 14: Gegenelektrode
- 15: Epitaxieschicht
- 16: Substrat
- 18: p⁺-Dotierungsbereich
- 20: Perforationsöffnungen
- 22: Abstandsschicht
- 24: Erste Anschlußelektrode
- 26: Zweite Anschlußelektrode
- 28: Isolationsschicht
- 30: Substratöffnung
- 32: Maskenschicht
- 34: Perforationsöffnungswiderstand
- 36: Zuströmwiderstand
- 40: Empfindlichkeit erfindungsgemäßes Mikrofon
- 42: Empfindlichkeit herkömmliches Mikrofon
- 50: Schlitzkreuz

## Patentansprüche

1. Mikromechanischer Sensor mit folgenden Merkmalen:
einer beweglichen Membran (10); und
einem der beweglichen Membran (10) über einen Hohlraum (12) gegenüberliegenden Gegenelement (14), in dem Perforationsöffnungen (20; 5d) gebildet sind,
**dadurch gekennzeichnet, daß** die Perforationsöffnungen (20; 50) durch Schlitze gebildet sind, deren Breite maximal dem doppelten des durch den Hohlraum (12) definierten Abstands zwischen der Membran (10) und dem Gegenelement (14) entspricht.

2. Mikromechanischer Sensor nach Anspruch 1, bei dem die Breite der Schlitze (20; 50) maximal 2 µm beträgt.

3. Mikromechanischer Sensor nach einem der Ansprüche 1 oder 2, bei dem die Länge der Schlitze (20; 50) zumindest das Doppelte der Breite derselben aber weniger als die Hälfte der Abmessung des Gegenelements (14) beträgt.

4. Mikromechanischer Sensor nach einem der Ansprüche 1 bis 3, bei dem die Schlitze in Reihen und senkrecht zu den Reihen verlaufenden Schlitzen angeordnet sind.

5. Mikromechanischer Sensor nach einem der Ansprüche 1 bis 4, bei dem die Perforationsöffnungen (20; 50) in unterschiedlichen Richtungen ausgebildete Schlitze sind.

6. Mikromechanischer Sensor nach Anspruch 4 oder 5, bei dem die Perforationsöffnungen (20; 50) durch erste Schlitze und senkrecht zu den ersten Schlitzen verlaufende zweite Schlitze gebildet sind.

7. Mikromechanischer Sensor nach einem der Ansprüche 4 bis 6, bei dem die ersten und zweiten Schlitze (20) abwechselnd in dem Gegenelement angeordnet sind.

8. Mikromechanischer Sensor nach einem der Ansprüche 1 bis 6, bei dem die Schlitze (50) Schlitzkreuze bilden.

9. Mikromechanischer Sensor nach Anspruch 8, bei dem Schlitzkreuze (50) in Reihen angeordnet sind und die Schlitzkreuze benachbarter Reihen versetzt zueinander sind.

10. Mikromechanischer Sensor nach einem der Ansprüche 1 bis 9, bei dem die Fläche der Perforationsöffnungen (20; 50) im wesentlichen 10 bis 50 % der Gesamtfläche des Gegenelements (14) beträgt.

11. Mikromechanischer Sensor nach einem der Ansprüche 1 bis 10, bei dem der mikromechanische Sensor ein Mikrofon ist, und bei dem das Gegenelement (14) eine Gegenelektrode ist.

12. Mikromechanischer Sensor nach Anspruch 11, bei dem das Mikrophon ein Ein-Chip-Mikrophon ist.

13. Verfahren zum Herstellen eines mikromechanischen Sensors, mit folgenden Schritten:
Erzeugen von schlitzförmigen Perforationsöffnungen (20; 50) in einer Schicht (15);
Erzeugen einer im wesentlichen planaren Oxidschicht (22) auf der Schicht (15), in der die Perforationsöffnungen (20) gebildet sind, mit einer Dicke, die dem späteren Abstand zwischen einem Gegenelement (14) und einer Membran (10) des mikromechanischen Sensors entspricht, unter Verwendung einer vorderseitigen Oxidabscheidung auf die mit den Perforationsöffnungen (20) versehene Schicht (15), wobei die Breite der schlitzförmigen Perforationsöffnungen (20; 50) maximal dem doppelten der Dicke der Oxidschicht (22) entspricht;
Aufbringen der Membran (10) auf die im wesentlichen planare Oxidschicht (22); und
Durchführen eines Ätzens zum Öffnen der Perforationsöffnungen (20) und zum Erzeugen eines Hohlraums (12) in der Oxidschicht (22) zwischen der Membran (10) und dem Gegenelement (14), in dem die Perforationsöffnungen (20) gebildet sind.

## Claims

1. A micromechanical sensor comprising:
a movable membrane (10); and
a counter element (14) in which perforation openings (20; 50) are formed, opposite to the movable membrane (10) via a cavity (12),
**characterized in that** the perforation openings (20; 50) are formed by slots, the width of which maximally corresponds to double the spacing defined by the cavity (12) between the membrane (10) and the counter element (14).

2. The micromechanical sensor according to claim 1, wherein the width of the slots (20; 50) is maximally 2 µm.

3. The micromechanical sensor according to claims 1 or 2, wherein the length of the slots (20; 50) is at least double the width of them but less than half the dimension of the counter element (14).

4. The micromechanical sensor according to one of claims 1 to 3, wherein the slots are arranged in rows and perpendicularly to the slots arranged in rows.

5. The micromechanical sensor according to one of claims 1 to 4, wherein the perforation openings (20; 50) are slots formed in different directions.

6. The micromechanical sensor according to claims 4 or 5, wherein the perforation openings (20; 50) are formed by first slots and second slots which are perpendicular to the first slots.

7. The micromechanical sensor according to one of claims 4 to 6, wherein the first and second slots (20) are arranged alternatingly in the counter element.

8. The micromechanical sensor according to one of claims 1 to 6, wherein the slots (50) form slot crosses.

9. The micromechanical sensor according to claim 8, wherein slot crosses (50) are arranged in rows and the slot crosses of neighboring rows are offset to one another.

10. The micromechanical sensor according to one of claims 1 to 9, wherein the area of the perforation openings (20; 50) basically is 10 to 50 % of the entire area of the counter element (14).

11. The micromechanical sensor according to one of claims 1 to 10, wherein the micromechanical sensor is a microphone and the counter element (14) is a counter electrode.

12. The micromechanical sensor according to claim 11, wherein the microphone is a one-chip microphone.

13. A method of manufacturing a micromechanical sensor, comprising the following steps:
producing slot-formed perforation openings (20; 50) in a layer (15);
producing an essentially planar oxide layer (22) on the layer (15) in which the perforation openings (20) are formed, with a thickness corresponding to the future distance between a counter element (14) and a membrane (10) of the micromechanical sensor, using a front-side oxide deposition on the layer (15) provided with the perforation openings (20), wherein the width of the slot-formed perforation openings (20; 50) maximally corresponds to double the thickness of the oxide layer (22);
depositing the membrane (10) onto the essentially planar oxide layer (22); and
performing of etching for opening the perforation openings (20) and for producing a cavity (12) in the oxide layer (22) between the membrane (10) and the counter element (14) in which the perforation openings (20) are formed.

## Revendications

1. Capteur micromécanique ayant les caractéristiques suivantes:
une membrane (10) mobile ; et
un élément (14) antagoniste qui est opposé à une membrane (10) mobile par l'intermédiaire d'une cavité (12) et dans lequel sont formées des ouvertures (20 ; 50) de perforation,
**caractérisé en ce que** les ouvertures (20 ; 50) de perforation sont formées par des fentes dont la largeur correspond au maximum à deux fois la distance définie par la cavité (12) entre la membrane (10) et l'élément (14) antagoniste.

2. Capteur micromécanique suivant la revendication 1, dans lequel la largeur des fentes (20 ; 50) est au maximum de 2 µm.

3. Capteur micromécanique suivant l'une des revendications 1 ou 2, dans lequel la longueur des fentes (20 ; 50) représente au moins le double de leur largeur mais moins que la moitié de la dimension de l'élément (14) antagoniste.

4. Capteur micromécanique suivant l'une des revendications 1 à 3, dans lequel les fentes sont disposées en rangées et en fentes s'étendant perpendiculairement aux rangées.

5. Capteur micromécanique suivant l'une des revendications 1 à 4, dans lequel les ouvertures (20 ; 50) de perforation sont des fentes ayant des directions différentes.

6. Capteur micromécanique suivant la revendication 4 ou 5, dans lequel les ouvertures (20 ; 50) de perforation sont formées par des premières fentes et par des deuxièmes fentes s'étendant perpendiculairement aux premières fentes.

7. Capteur micromécanique suivant l'une des revendications 4 à 6, dans lequel les premières et les deuxièmes fentes (20) sont disposées en alternance dans l'élément antagoniste.

8. Capteur micromécanique suivant l'une des revendications 1 à 6, dans lequel les fentes (50) forment des croix de fentes.

9. Capteur micromécanique suivant la revendication 8, dans lequel les croix (50) de fentes sont disposées en rangées et les croix de fentes de rangées voisines sont décalées les unes par rapport aux autres.

10. Capteur micromécanique suivant l'une des revendications 1 à 9, dans lequel la superficie des ouvertures (20 ; 50) de perforation représente sensiblement de 10 à 50 % de la superficie totale de l'élément (14) antagoniste.

11. Capteur micromécanique suivant l'une des revendications 1 à 10, dans lequel le capteur micromécanique est un microphone et dans lequel l'élément (14) antagoniste est une électrode antagoniste.

12. Capteur micromécanique suivant la revendication 11, dans lequel le microphone est un microphone à une seule puce.

13. Procédé de fabrication d'un capteur micromécanique comprenant les stades suivants :
production d'ouvertures (20 ; 50) de perforation en forme de fente dans une couche (15) ;
production d'une couche (22) d'oxyde sensiblement plane sur la couche (15), dans laquelle sont formées les ouvertures (20) de perforation en une épaisseur, qui correspond à la distance ultérieure entre un élément (14) antagoniste et une membrane (10) du capteur micromécanique avec utilisation d'un dépôt d'oxyde du côté avant sur la couche (15) munie des ouvertures (20) de perforation, la largeur des ouvertures (20 ; 50) de perforation en forme de fente correspondant au maximum à deux fois l'épaisseur de la couche (22) d'oxyde ;
dépôt de la membrane (10) sur la couche (22) d'oxyde sensiblement plane ; et
mise en oeuvre d'une attaque pour ouvrir les ouvertures (20) de perforation et pour produire une cavité (12) dans la couche (22) d'oxyde entre la membrane (10) et l'élément (14) antagoniste, dans lequel sont formées les ouvertures (20) de perforation.
